Europäisches Patentamt

(19) European Patent Office

Office européen des brevets

(11) **EP 1 332 549 B1**

(12) **EUROPÄISCHE PATENTSCHRIFT**

(45) Veröffentlichungstag und Bekanntmachung des Hinweises auf die Patenterteilung:
**17.11.2004 Patentblatt 2004/47**

(21) Anmeldenummer: **01978175.6**

(22) Anmeldetag: **20.09.2001**

(51) Int Cl.⁷: **H03D 3/02**

(86) Internationale Anmeldenummer:
**PCT/DE2001/003647**

(87) Internationale Veröffentlichungsnummer:
**WO 2002/025805 (28.03.2002 Gazette 2002/12)**

(54) **PHOTOELEKTRONISCHE MISCHERSCHALTUNG**

PHOTOELECTRONIC MIXING DEVICE (PMD) SYSTEM

SYSTEME DE DISPOSITIF MELANGEUR PHOTOELECTRIQUE (PMD)

(84) Benannte Vertragsstaaten:
**DE FR GB**

(30) Priorität: **22.09.2000 DE 10047170**

(43) Veröffentlichungstag der Anmeldung:
**06.08.2003 Patentblatt 2003/32**

(73) Patentinhaber: **SIEMENS AKTIENGESELLSCHAFT**
**80333 München (DE)**

(72) Erfinder:
• **GULDEN, Peter**
**57078 Siegen (DE)**
• **HEIDE, Patric**
**85591 Vaterstetten (DE)**
• **VOSSIEK, Martin**
**31139 Hildesheim (DE)**

(56) Entgegenhaltungen:
**DE-A- 4 439 298**

• **GULDEN P ET AL: "APPLICATION OF THE PHOTOELECTRONIC MIXING DEVICE TO OPTICAL MEASUREMENT OF PRESENCE, DISTANCE AND VELOCITY" 30TH EUROPEAN MICROWAVE CONFERENCE PROCEEDINGS. PARIS, OCT. 3 - 5, 2000, PROCEEDINGS OF THE EUROPEAN MICROWAVE CONFERENCE, LONDON: CMP, GB, Bd. 3 OF 3 CONF. 30, 5. Oktober 2000 (2000-10-05), Seiten 108-111, XP001060988 ISBN: 0-86213-212-6**
• **HEINOL H G ET AL: "PHOTOMISCHDETEKTOR ERFASST 3D-BILDER NEUES OPTISCHES BAUELEMENT VEREINIGT DETEKTION UND MISCHUNG" ELEKTRONIK, FRANZIS VERLAG GMBH. MUNCHEN, DE, Bd. 48, Nr. 12, 15. Juni 1999 (1999-06-15), Seite 80,82,84,86,88,90 XP000913168 ISSN: 0013-5658**
• **SCHWARTE R ET AL: "NEUARTIGE 3D-VISIONSYSTEME AUF DER BASIS LAYOUT-OPTIMIERTER PMD- STRUKTUREN" TECHNISCHES MESSEN TM, R.OLDENBOURG VERLAG. MUNCHEN, DE, Bd. 65, Nr. 7/8, Juli 1998 (1998-07), Seiten 264-271, XP000847213 ISSN: 0171-8096**

**Beschreibung**

Die Erfindung betrifft ein PMD-("Photoelectronic Mixing Device"-)System sowie Verfahren zur Regelung eines PMD-Systems.

Ein PMD entspricht im Prinzip einem Pixel eines CMOS-Kamerachips. Im PMD kann neben der Intensität auch die Laufzeit einer von einem Sender gesendeten und vom PMD empfangenen intensitätsmodulierten Lichtwelle gemessen werden. Im PMD generiert das Licht wie auf einer konventionellen Photodiode Ladungsträger, deren Anzahl proportional zur Intensität des Lichtes ist.

Die Besonderheit der PMD-Anordnung besteht darin, dass wechselweise zwei gegenüberliegende Ausgänge A und B geöffnet werden. Das Umschalten zwischen den beiden Ausgängen erfolgt über eine Modulationsspannung $U_{mod}$, die an das PMD angelegt wird. Diese Modulationsspannung $U_{mod}$ wird mit derselben Frequenz $f_{mod}$ moduliert wie die Amplitude der vom Sender abgestrahlten Lichtwelle. Gelangt nun das Licht ohne Verzögerung auf das PMD, dann entspricht die Zeit, in der Ladungsträger generiert werden, der Öffnungszeit von Ausgang A. Die erzeugten Ladungen gelangen somit vollständig auf Ausgang A. Trifft die Lichtwelle verzögert auf das PMD, dann werden die Ladungsträger entsprechend später generiert. Somit wird ein Teil der Ladungen während der Öffnungszeit von Ausgang A erzeugt, ein weiterer Teil dagegen während der Öffnungszeit von Ausgang B. Deshalb ist die Differenz zwischen Ausgang A und Ausgang B ein Maß für die Laufzeit des Signals, die Summe von A und B dagegen ein Maß für die Intensität des einfallenden Lichtes, siehe dazu: DE 197 04 496 A1, oder R. Schwarte et al., "Schnelle und einfache optische Formerfassung mit einem neuartigen Korrelations-Photodetektor-Array", Vortrag auf der DGZfP-GMA Fachtagung in Langen, 28./29 April 1997.

Die Auslesespannungen $U_a$ von Ausgang A und $U_b$ von Ausgang B werden im sogenannten nicht-integrierender Betrieb direkt durch den generierten Ladungsstrom erzeugt. Bei dem sogenannten integrierendem Betrieb sind die Auslesespannungen $U_a$ und $U_b$ diejenigen Spannungen, die nach Integration der Ladungen an den Ladungstöpfen entstehen. Integrierende PMDs weisen die Besonderheit auf, dass die Töpfe, in denen die Ladungsträger gesammelt werden, regelmäßig mittels eines Reset-Signals R geleert werden müssen. Das Reset kann entweder nach fest vorgegebenen Zeitintervallen $t_i$ mit der Frequenz $f_i = 1/t_i$ erfolgen, oder adaptiv bei Erreichen einer gewissen Spannungsschwelle an den Ladungstöpfen.

Für die Ausgangssignale $U_a$ und $U_b$ des PMD, die dem Produkt der einfallenden elektromagnetischen Wellen mit dem Modulationssignal $U_{PMDmod}$ bzw. dem um 180° phasenverschobenen Modulationssignal $\bar{U}_{PMDmod}$ entsprechen, gilt bei sinusförmiger Modulation, je nach Ausführung der Akkumulationsgates (integrierend/nicht integrierend), unter Annahme von gleicher Frequenz der einfallenden intensitätsmodulierten Lichtwelle und des Modulationssignals, und mit anschließender Unterdrückung hochfrequenter Anteile:

a) bei integrierender Ausführung:

$$U_a = \kappa \cdot t_i \cdot P_M \cdot \cos(\Delta\varphi) + \kappa \cdot t_i \cdot P_H/2 \quad (1.1)$$

$$U_b = \kappa \cdot t_i \cdot P_M \cdot \cos(\Delta\varphi + 180°) + \kappa \cdot t_i \cdot P_H/2$$

$$(1.2)$$

b) bei nicht integrierender Ausführung:

$$U_a = \kappa \cdot P_M \cdot \cos(\Delta\varphi) + \kappa \cdot P_H/2 \quad (2.1)$$

$$U_b = \kappa \cdot P_M \cdot \cos(\Delta\varphi + 180°) + \kappa \cdot P_H/2 \quad (2.2)$$

Dabei entspricht $\Delta\varphi$ der Phasenverschiebung zwischen der einfallenden Lichtwelle und dem Modulationssignal, $P_M$ der Leistung der einfallenden Welle, $t_i$ der Integrationszeit, $\kappa$ einem die Empfindlichkeit des PMD und die Amplitude der Modulationsspannung berücksichtigender Proportionalitätsfaktor und $P_H$ der Leistung der Hintergrundbeleuchtung. Durch Bildung des Differenzsignals wird die Hintergrundbeleuchtung unterdrückt, und es gilt für das Differenzsignal $U_d = U_a - U_b$ :

$$U_d = 2 \cdot \kappa \cdot t_i \cdot P_M \cdot \cos(\Delta\varphi) \quad (3),$$

bzw.

$$U_d = 2 \cdot \kappa \cdot P_M \cdot \cos(\Delta\varphi) \quad (4).$$

Problematisch für die direkte Berechnung der Phasenverschiebung ist die Abhängigkeit der Ausgangssignale sowohl von $\cos(\Delta\varphi)$ als auch von $P_M$.

Die Phasenverschiebung $\Delta\varphi$ setzt sich aus der Phasendifferenz durch die Laufzeit $\varphi_{tof}$ und der Phasendifferenz durch die (einstellbare) Phasenverzögerung $\varphi_d$ zusammen. Damit gilt mit der Laufzeit $\tau_{tof}$, der Modulationsfrequenz $f_{mod}$ und einer additiven Phasenverzögerung $\varphi_d$:

$$\Delta\varphi = \varphi_{tof} + \varphi_d = 2\pi \cdot f_{mod} \cdot \tau_{tof} + \varphi_d \quad (5)$$

Idealerweise ist $\varphi_d$ null, beziehungsweise ein exakt einstellbarer Wert. Wird Gl. (5) zur Bestimmung der Entfernung nach der Laufzeit $\tau_{tof}$ umgestellt, so gilt:

$$d = \frac{c}{2} \cdot \frac{\Delta\varphi - \varphi_d}{2 \cdot \pi \cdot f_{mod}} \qquad (6)$$

Es ist die Aufgabe der vorliegenden Erfindung, eine Möglichkeit zur verbesserten Bestimmung der Laufzeit $\tau_{tof}$ und/oder der laufzeitbedingten Phasendifferenz eines PMD-Systems bereitzustellen.

Diese Aufgabe wird durch ein PMD-System gemäß Patentanspruch 1 sowie Verfahren zur Regelung einen PMD-Systems gemäß der Ansprüche 18 und 19 gelöst.

Dazu weist ein PMD-System mindestens ein PMD-Element sowie mindestens einen Sender zur intensitätsmodulierten Aussendung elektromagnetischer Wellen auf. Das PMD-Element kann integrierend oder nicht-integrierend ausgeführt sein. Der Sender ist typischerweise eine Lichtquelle, kann aber auch andere geeignete elektromagnetische Strahlung aussenden, z. B. allgemeine Funkwellen wie Mikrowellen oder Radarwellen.

Weiterhin ist mindestens eine Ansteuerelektronik vorhanden, mittels der das PMD-Element und der Sender mit jeweils mindestens einer Modulationsspannung gleicher Modulationsfrequenz ansteuerbar sind. Dabei kann die Signalhöhe der Modulationsspannungen für PMD-Element und Sender voneinander abweichen, beispielsweise zur Anpassung an eine gerätespezifische Kenngröße wie einen maximalen Eingangspegel. Die Ansteuerelektronik kann sowohl von außen mit einem Taktsignal gespeist werden oder einen Frequenzgenerator beinhalten.

Die Ansteuerelektronik kann eine Phasenverschiebung $\Delta\varphi$ verändern. Dies geschieht nach Gl. (5) durch eine Änderung der Modulationsfrequenz $f_{mod}$ und/oder durch eine Einstellung der Phasenverzögerung $\varphi_d$. Die Veränderung der Phasenverschiebung $\Delta\varphi$ wird über ein an die Ansteuerelektronik geleitetes Stellsignal gesteuert.

Zusätzlich ist eine Regelstrecke vorhanden, in die als eine Regelgröße $U'_d$ mindestens ein Ausgangssignal $U_a, U_b$ oder eine Kombination der Ausgangssignale, z.B. das Differenzsignal $U_d$ des PMD-Elements, einspeisbar ist. Die Regelstrecke kann entweder analog oder digital ausgeführt werden. Das mindestens eine Ausgangssignal $U_a, U_b, U_d$ kann direkt als Regelgröße $U'_d$ verwendet werden oder nach einer Signalbearbeitung, beispielsweise einer Subtraktion zweier Ausgangssignale $U_a, U_b$ und/oder einer folgenden Signalvorverarbeitung.

Die Regelstrecke ist mit der Ansteuerelektronik verbunden, so dass ein Ausgangssignal als Stellsignal der Ansteuerelektronik verwendet wird. Dadurch ist durch die Regelstrecke die Phasenverschiebung $\Delta\varphi$ so regelbar, dass die Regelgröße $U'_d$ auf den Wert einer vorgegebenen Zielgröße einstellbar ist. Dadurch kann sich das PMD-System als Regelkreis selbsttätig einregeln. Mittels der Regelstrecke wird also eine das PMD-System bzw. den Regelkreis charakterisierende Regelgröße $U'_d$ auf die Zielgröße eingeregelt.

Die Phasenverzögerung $\varphi_d$ kann direkt eingestellt werden, z. B. über einen Phasenschieber. Alternativ oder zusätzlich kann die Modulationsfrequenz $f_{mod}$ variiert werden. Bei beiden Arten wird die Variation bevorzugt so durchgeführt, dass die gesamte Phasendifferenz $\Delta\varphi$ aus Gl.(5) einem charakteristischen Wert entspricht, z.B. 90°, 180°, 270° bzw. 360°. Dies entspricht jeweils einer Regelgröße $U'_d = 0$, min, 0 bzw. max. Bei einer Einstellung von $U'_d =$ minimal oder maximal können ein zur Leistung des empfangenen modulierten Lichtes $P_M$ und ein zum Hintergrundlicht $P_H$ proportionales Spannungssignal erzeugt werden. Sämtliche Signale stehen vorteilhafterweise unabhängig voneinander zur Verfügung, die gewünschten Phasenund Intensitätsinformationen können mit einer einzelnen Messung aufgenommen werden. Es sind aber auch Einstellungen auf andere charakteristische Größen möglich.

Bei einer Verwendung der Frequenz zur Regelung des PMD-Systems ist es vorteilhaft, wenn zu Beginn einer Regelung die niedrigste Frequenz als Startpunkt gewählt wird, und dann in Richtung der nächsthöheren Frequenz geregelt wird, welche den gewünschten Wert der Regelgröße $U'_d$ einstellt.

Es ist wegen der Unterbrechungen durch das Reset der integrierenden PMDs vorteilhaft, wenn der Regelstrecke eine Einrichtung zur Signalvorverarbeitung vorgeschaltet ist.

Es ist wegen des speziellen Verlaufs der Ausgangsignale integrierender PMDs insbesondere günstig, wenn die Einrichtung zur Signalvorverarbeitung mindestens einen ersten Tiefpassfilter, dahinter eine Vorrichtung zur zeitlichen Differenzierung, dahinter einen durch ein Resetsignal steuerbaren Schalter und dahinter einen zweiten Tiefpassfilter aufweist. Das Resetsignal kann normal oder bearbeitet, z. B. invertiert, sein.

Es kann zur Unterdrückung von Störungen durch den steuerbaren Schalter auch vorteilhaft sein, wenn die Einrichtung zur Signalvorverarbeitung mindestens einen Tiefpassfilter, dahinter einen durch ein Resetsignal steuerbaren Schalter und dahinter ein Sample-and-Hold-Tor aufweist.

Es kann zur einfachen technischen Realisierung auch günstig sein, wenn die Einrichtung zur Signalvorverarbeitung mindestens einen ersten Tiefpassfilter, dahinter eine Vorrichtung zur zeitlichen Differenzierung und dahinter einen zweiten Tiefpassfilter aufweist.

Auch ist es zur empfindlichen und gleichzeitig stabilen Differenzierung des Signals bei einer Signalvorverarbeitung günstig, wenn eine Grenzfrequenz des ersten Tiefpassfilters im Bereich des 5,5-fachen der Integrationsfrequenz $f_{ti}$ liegt, insbesondere, wenn eine Grenzfrequenz des zweiten Tiefpassfilters im Bereich des dreifachen der Integrationszeit $f_{ti}$ liegt.

Es ist günstig, wenn die das PMD-Element ansteuernde mindestens eine Modulationsspannung und die den Sender ansteuernde mindestens eine Modulationsspannung gegeneinander mit einer Phasenverzögerung $\varphi_d$ versehbar sind. Dies kann beispielsweise durch eine Phasenverzögerung $\varphi_d$ einer der beiden Modulationsspannungen oder durch unterschiedliche Phasenverzögerung der beiden Modulationsspannungen geschehen.

Zur verbesserten Bestimmung einer Einstellung der Phasenverzögerung $\varphi_d$ ist vorteilhafterweise mindestens ein Phasenkomparator, der die Phase mindestens einer am PMD-Element anliegenden und mindestens einer am Sender anliegenden Modulationsspannung vergleicht. Dies geschieht zum Beispiel dadurch, dass der an einem Eingang des Phasenkomparators eine das PMD-Element ansteuernde Modulationsspannung anliegt und an einem weiterem Eingang eine den Sender ansteuernde Modulationsspannung. Durch Vergleich der mindestens zwei Modulationsspannungen wird eine Phasendifferenz bestimmt.

Es ist vorteilhaft, wenn die Ansteuerelektronik mindestens einen mittels eines Taktsignals steuerbaren Treiber beinhaltet, der das PMD-Element mit der mindestens einen Modulationsspannung ($U_{mod}$, $\bar{U}_{mod}$) versorgt. Das Taktsignal kann sowohl von einer externen Signalquelle bereitgestellt werden oder auch durch einen in der Ansteuerelektronik vorhandenen Taktgeber, z. B. einen Frequenzgenerator, erzeugt werden. Zudem ist ein durch die Regelstrecke steuerbarer Phasenverzögerer vorhanden, mittels dessen das Taktsignal als Modulationsspannung an den Sender mit einer Phasenverzögerung $\varphi_d$ weiterleitbar ist. Es ist aber auch möglich, den Phasenverzögerer, günstigerweise einen Phasenschieber, vor dem PMD-Element einzubringen.

Es wird insbesondere bevorzugt, den Phasenverzögerer in Form eines Phasenschiebers auszubilden, welcher einen Komparator mit einem nachgeschalteten D-Flipflop als Takthalbierer enthält. Dies ist besonders vorteilhaft, wenn das PMD-System als ein integrierter Baustein vorliegt, z. B. wenn ein solcher Phasenschieber sowie eine Regelstrecke in das PMD-Element integriert sind. Dadurch steht in jedem PMD-Baustein PMD ein direkt von der Laufzeit $\tau_{tof}$ bzw. der Entfernung vom Objekt abhängiges Signal, typischerweise ein Spannungswert, zur Verfügung. Dies ist insbesondere günstig bei der Verwendung in einer Matrix aus mehreren PMD-Bausteinen bzw. PMD-Elementen. Eine Matrix aus mehreren der oben genannten PMD-Systeme wird aber auf bei anderen Bauformen bevorzugt.

Es ist zur Regelung des PMD-Systems über die Modulationsfrequenz $f_{mod}$ auch günstig, wenn das PMD-System mindestens eine Ansteuerelektronik beinhaltet, die einen mittels eines Taktsignals steuerbaren Treiber enthält, der das PMD-Element mit der mindestens einen Modulationsspannung versorgt sowie eine steuerbare Frequenzquelle, der das Taktsignal für den Treiber und die Modulationsspannung für den Sender erzeugt. Insbesondere wird ein spannungsgesteuerter Oszillator bevorzugt. Die steuerbare Frequenzquelle kann z. B. ein spannungsgesteuerter Oszillator ("Voltage Controlled Oscillator", VCO), ein Baustein zur digitalen Direktsynthese ("Direct Digital Synthesis",DDS) oder ein PLL-("Phase Lock Loop"-)Baustein sein.

Zur vereinfachten Messung der eingeregelten Frequenz des PMD-Systems über die Frequenz ist es vorteilhaft, wenn das eingeregelte Taktsignal der steuerbaren Frequenzquelle in einen f-zu-U-Konverter, insbesondere einen inkrementell zählenden f-zu-U-Konverter, eingespeist wird.

Die Messwerte des PMD-Systems können direkt analog oder digital weiterverarbeitet werden, z.B. für eine geeignete Mittelung.

In den folgenden Ausführungsbeispielen wird die Methode zur Bestimmung der Phasendifferenz schematisch näher dargestellt.

Fig. 1   zeigt ein typisches Ausgangs- und Resetsignal eines PMD-Elements nach dem Stand der Technik,

Fig. 2   zeigt ein PMD-System nach dem Stand der Technik mit veränderbarer Phasenverzögerung $\varphi_d$,

Fig. 3   zeigt ein PMD-System nach dem Stand der Technik mit veränderbarer Modulationsfrequenz $f_{mod}$,

Fig. 4   zeigt ein PMD-System mit veränderbarer Phasenverzögerung $\varphi_d$ und Regelstrecke,

Fig. 5   zeigt mehrere Ausführungsformen einer Einrichtung zur Signalvorverarbeitung,

Fig. 6   zeigt verschiedene zur Einrichtung zur Signalvorverarbeitung gehörige Signale,

Fig. 7   zeigt ein weiteres PMD-System mit veränderbarer Phasenverzögerung $\varphi_d$ und analoger Regelstrecke,

Fig. 8   zeigt verschiedene zum PMD-System aus Figur 7 gehörige Signalverläufe,

Fig. 9   zeigt ein PMD-System mit veränderbarer Modulationsfrequenz $f_{mod}$ und Regelstrecke.

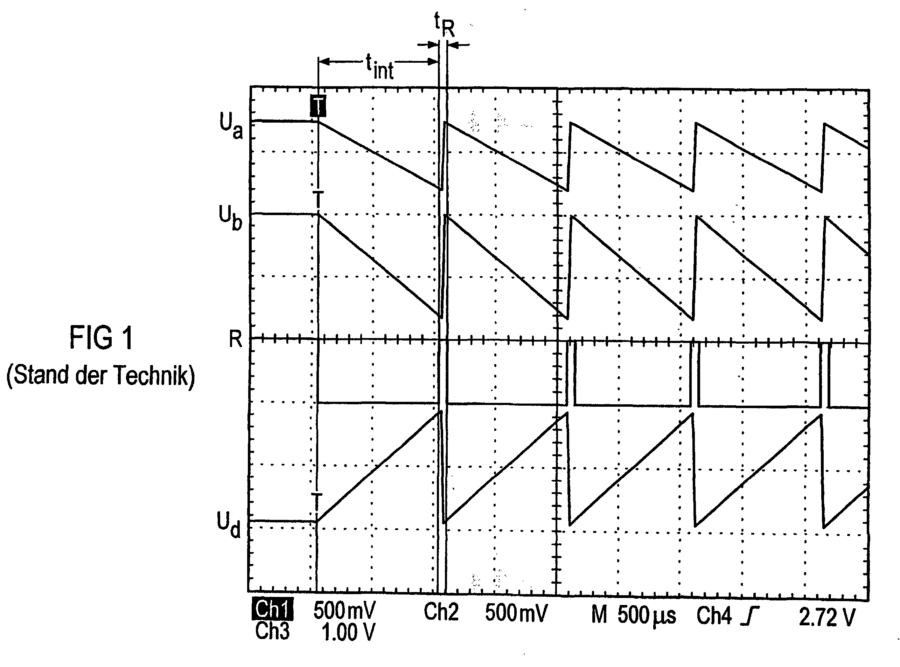

In Figur 1 sind die Ausgangssignale $U_a$ und $U_b$ eines PMD-Elements PMD, das Differenzsignal $U_d$ sowie das Resetsignal R eines Mikroprozessors MP in V aufgetragen gegen die Zeit t in $\mu$s für ein integrierendes PMD-Element PMD nach Schwarte et al.: "A new electrooptical mixing and correlating sensor: Facilities and Applications of the Photonic Mixer Device (PMD)", Presentation at Laser 97, Munich, aufgetragen.

Die Ausgangssignale $U_a$ und $U_b$ sind innerhalb einer Zeitdauer $t_{int}$ abschnittsweise linear und werden durch ein Resetsignal R der Zeitdauer $t_R$ zurückgesetzt.

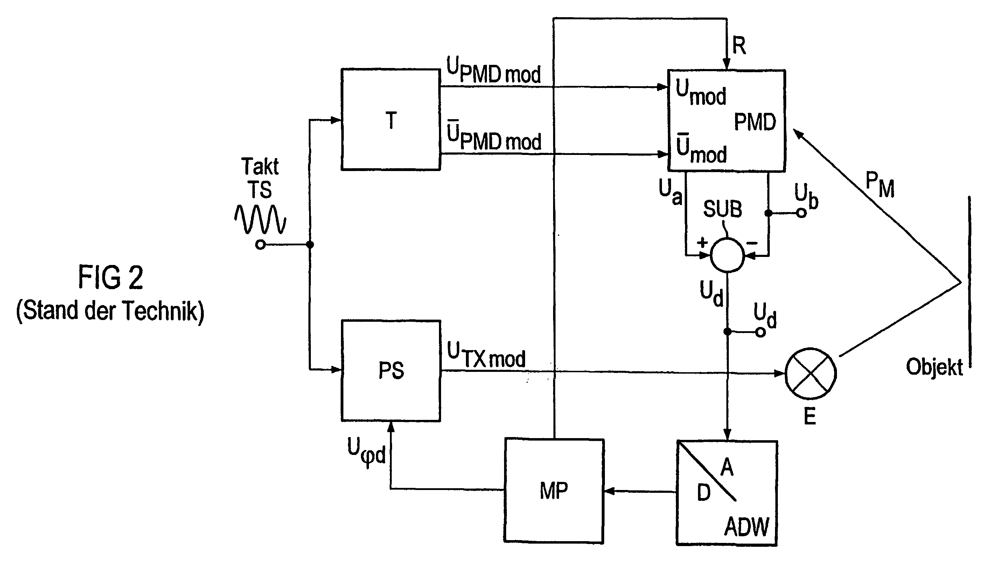

Figur 2 zeigt als Schaltskizze ein PMD-System zur Bestimmung der Phasenverschiebung mittels eines PSK-Verfahrens nach Heinol et al.: "Laufzeitbasierte 3D-Kamereasysteme - Smart Pixel Lösungen", DGZIP Fachtagung Optische Formerfassung, Stuttgart 5.-6. September 1999.

Dabei werden ein verstellbarer Phasenschieber PS und ein Treiber T mittels eines Taktsignals TS, das typischerweise von einem Taktgeber generiert wird, getaktet. Der Treiber T leitet das Modulationssignal $U_{PMDmod}$ und das um 180° phasenverschobene Modulationssignal $\bar{U}_{PMD\ mod}$ an das PMD-Element PMD weiter. Vom PMD-Element PMD werden anhängig unter anderem von einer Leistung $P_M$ der einfallenden Welle die Ausgangssignale $U_a$ und $U_b$ erzeugt. Das zugehörige Differenzsignal $U_d$ kann entweder digital ermittelt werden, oder mittels eines, bevorzugt analogen, Subtrahierers SUB. Dieser Subtrahierer SUB kann in das PMD-Pixel integriert sein.

Das Differenzsignal $U_d$ wird über einen A/D-Wandler ADW in einen Mikroprozessor MP eingegeben, der unter anderem abhängig vom Wert des Differenzsignals $U_d$ sowohl das Resetsignal R an das PMD-Element PMD weitergibt als auch das Phasensignal $U_{\varphi d}$ an den Phasenschieber PS. Der Phasenschieber PS wird vom Mikroprozessor MP somit auf eine bestimmte Phasenverzögerung $\varphi_d$ eingestellt.

Der Sender E wird über das für ihn bestimmte Modulationssignal $U_{TXmod}$ vom Phasenschieber PS angesteuert. $U_{PMDmod}$ und $U_{TXmod}$ unterscheiden sich zur Anpassung an die angesteuerten Geräte lediglich in ihrer Signalhöhe.

Die vom Sender E ausgestrahlte intensitätsmodulierte Lichtwelle läuft über die Übertragungsstrecke und gelangt mit der Phasendifferenz $\Delta\varphi = \varphi_d + \varphi_{tof}$ auf das PMD-Elyment PMD, wobei $\varphi_{tof}$ die durch das Zurücklegen der Strecke Sender-PMD verursachte Phasen-/Laufzeitdifferenz ist. Das PMD-Element PMD erzeugt dann die Ausgangssignale $U_a$, $U_b$ nach Gleichung (1.1)-(1.2), bzw. (2.1)-(2.2). Anschließend wird das Differenzsignal $U_d$ nach Gl. (3) bzw. (4) gebildet und mittels des A/D-Wandlers ADW digitalisiert. Der Mikroprozessor MP speichert das Ergebnis, und stellt einen neuen Phasenverzögerungswert $\varphi_d$ ein. Auf diese Weise werden die Werte des Ausgangssignals $U_d$ für verschiedene diskrete Werte der Phasenverzögerungen $\varphi_d$ im Bereich 0° bis 360° aufgenommen. Die resultierende Korrelationskurve weist ein Maximum bei $\Delta\varphi = 360°$ auf. $\varphi_{tof}$ lässt sich dann über die exakte Bestimmung des Maximums mittels Interpolation aus den diskreten Messwerten bestimmen, man erhält $\varphi_{tof} = 360° - \varphi_d$ $(U_{d;max})$.

Der entstehende technische Aufwand dieser Methode ist beträchtlich, so müssen mehrere Messwerte aufgenommen und gespeichert werden, anschließend muss das Minimum bzw. Maximum gesucht werden. Zusätzlicher Rechenaufwand entsteht durch die Verwendung von Interpolationsverfahren zur möglichst exakten Bestimmung des Maximums. Beispielsweise wird in Heinol et al. die Phasenverzögerung mittels direkter digitaler Frequenzsynthese ("DDS") und digitalem Phasenregister erzeugt.

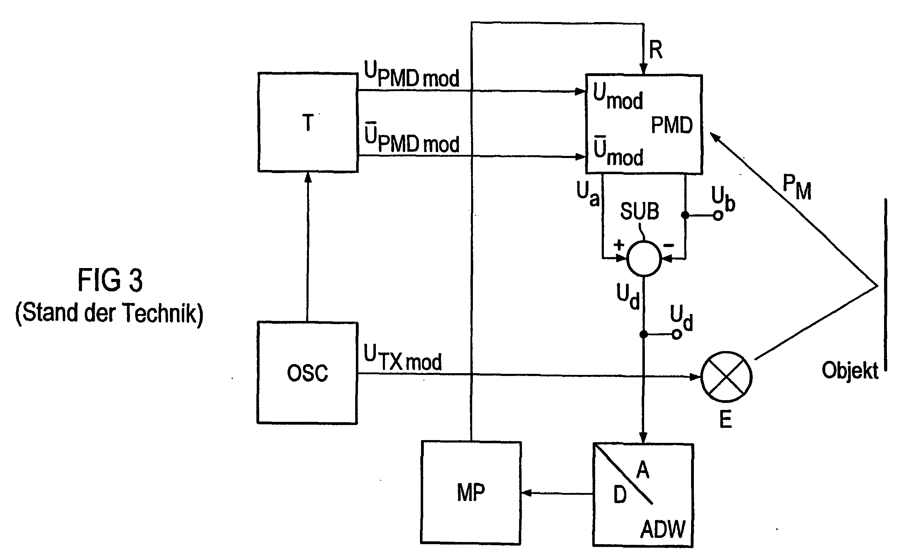

Figur 3 zeigt als Schaltskizze ein PMD-System mit veränderbarer Modulationsfrequenz $f_{mod}$ ohne Regelstrecke CTR.

Ein verstimmbarer Oszillator OSC sendet ein Modulationssignal $U_{mod}$ mit einer ersten Modulationsfrequenz $f_{mod}$. Sein Ausgangssignal $U_{TX\ mod}$ wird vom Sender E intensitätsmoduliert gesendet und gelangt gleichzeitig über den Treiber T, als $U_{PMDmod}$ auf das PMD. Dort wird es analog zu Figur 2 überlagert. Das Differenzsignal $U_d$ wird direkt vom A/D-Wandler abgetastet und im Mikroprozessor MP abgelegt. Dort erfolgt eine Spektralanalyse zur Bestimmung der Dopplerfrequenz und die Berechnung der Phase. Der Mikroprozessor MP stellt dann einen neuen Wert der Modulationsfrequenz $f_{mod}$ ein, und der nächste Wert für $U_d$ wird aufgenommen. Auch wird ggf. bei integrierendem PMD, dem sinnvollerweise ein Differenzierer nachgeschaltet ist, ein Resetsignal R vom Mikroprozessor MP zum PMD gesendet.

Die Entfernungsberechnung kann entweder durch direktes Lösen der Gleichungen für die Laufzeit $t_{tof}$ und des Faktors $\kappa$ (beim FSK-Verfahren), über eine Maximasuche in der Korrelationskurve (beim FSK-Verfahren), oder mittels Fourierauswertung (FMCW-Verfahren) erfolgen. Von Nachteil sind dabei wiederum die Aufnahme mehrerer Messwerte, und die Notwendigkeit zur mathematischen Auswertung der Messdaten.

Zur Bestimmung der Phasendifferenz bzw. Laufzeitdifferenz ist die Aufnahme mehrerer Messwerte beispielsweise mittels PSK-("Phase Shift Key"), FSK-("Frequency Shift Key"), FMCW-("Frequency Modulated Continuous Wave") oder PN-Modulation möglich.

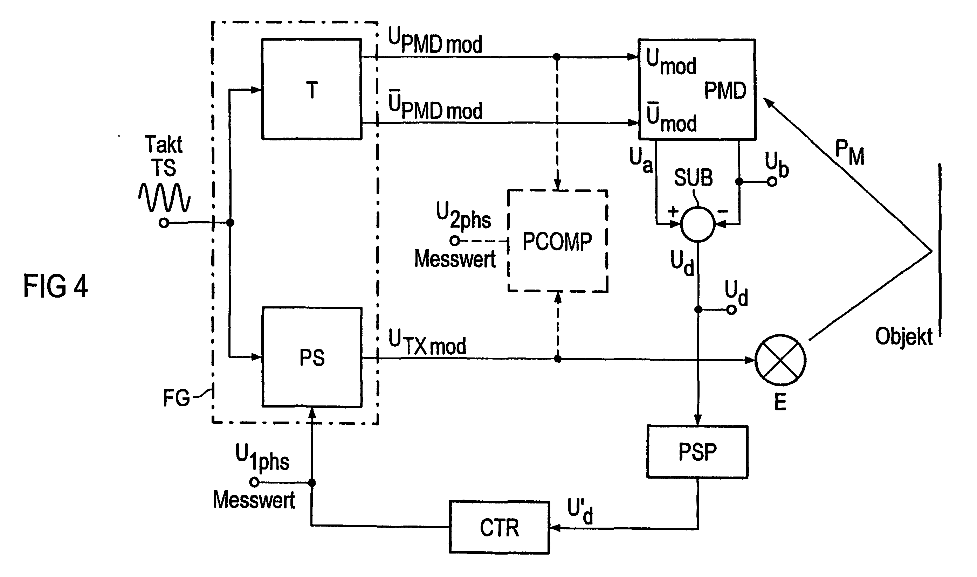

Figur 4 zeigt als Schaltbild ein PMD-System mit variabler Phasenverzögerung $\varphi_d$ und Regelstrecke CTR.

Das PMD-System weist einen modulierbaren Sender E, ein PMD-Element PMD, einen PMD-Treiber T, ein durchstimmbares Phasenverzögerungselement in Form eines Phasenschiebers PS, einen Subtrahierer SUB, eine Regelstrecke CTR und eine Einrichtung zur Signalvorverarbeitung PSP auf. Zur Erhöhung der Genauigkeit kann zusätzlich ein Phasenkomparator PCOMP eingefügt werden.

Das Takteingangssignal TS wird auf den PMD-Treiber T und den Phasenschieber PS gegeben. Der PMD-Treiber T erzeugt aus dem Taktsignal TS die Modulationsspannung $U_{PMD\ mod}$ und das um 180° verschobene Komplementärsignal $\bar{U}_{PMD\ mod}$. Diese beiden Spannungen werden auf das PMD-Element PMD gegeben. Der Phasenschieber PS verzögert das Taktsignal TS um die Phasenverzögerung $\varphi_d$, bevor es auf den Sender E geführt wird. Die Phasenverzögerung $\varphi_d$ ist dabei abhängig von der am Phasenschieber PS anliegenden Regelgröße $U_{1phs}$. Das phasenverzögerte Signal $U_{TXmod}$ wird vom Sender E gesendet und gelangt über die Übertragungsstrecke mit der Phasenverzögerung $\Delta\varphi = \varphi_d + \varphi_{tof}$ auf das PMD-Element PMD.

An den Ausgangsgates des PMD-Elements PMD entstehen die in den Gl. (1.1), (1.2), bzw. (2.1),(2.2) beschriebenen Ausgangssignale $U_a$ und $U_b$, die proportional zu $\Delta\varphi$ sind. Aus den Ausgangssignalen $U_a$, $U_b$ wird das Differenzsignal $U_d$ gemäß Gleichung (3) bzw. (4) gebildet. Das Differenzsignal $U_d$ wird, ggf. im Anschluss an eine Signalvorverarbeitung in der Einrichtung zur Signalvorverarbeitung PSP, als Regelgröße $U'_d$ in die Regelstrecke CTR gegeben. Ohne Signalvorverarbeitung entspricht $U_d = U'_d$.

Über ein von der Regelstrecke CTR ausgegebenes Signal, hier: eine Spannung $U_{1phs}$, wird der Phasenschieber PS so ausgeregelt, dass die Regelgröße $U'_d$ einer vorgegebenen Zielgröße möglichst genau entspricht. Die Spannung $U_{1phs}$ ist dann ein Maß für die Phasenverzögerung $\varphi_d$ zwischen gesendetem und empfangenem Licht.

Zur Erhöhung der Genauigkeit kann ein zusätzlicher Phasenkomparator PCOMP zur Bestimmung der eingestellten Phasenverzögerung $\varphi_d$ eingesetzt werden. Dessen Ausgangsspannung $U_{2phs}$ stellt dann ebenfalls ein Maß für die Phasenverzögerung $\varphi_d$ dar. In diesem Ausführungsbeispiel ist der Phasenkomparator PCOMP an einen Ausgang des Treibers T und an einen Ausgang des Phasenschiebers PS angeschlossen und vergleicht $U_{PMDmod}$ mit $U_{TXmod}$.

Mögliche Zielgrößen, die sich für den Regelkreis besonders eignen, sind:

    a) $U'_d = 0$;
    b) $U'_d$ = maximal;
    c) $U'_d$ = minimal.

Fall a): Für $U'_d = 0$ stellt sich automatisch $\Delta\varphi = 90°$ ein, siehe Gl. (3), bzw. (4). In diesem Fall entspricht die durch die Laufzeit $t_{tof}$ verursachte Phasenverzögerung $\varphi_{tof} = 90 - \varphi_d$. Die Phasenverzögerung $\varphi_d$, und somit $\varphi_{tof}$ ist direkt aus der Kennlinie des Phasenschiebers PS bzw. der eingeregelten Spannung $U_{1phs}$ bestimmbar.

Zur Erhöhung der Messgenauigkeit kann $\varphi_d$ auch direkt aus dem Ausgangssignal $U_{2phs}$ des Phasenkomparators PCOMP bestimmt werden. Mit der Zielgröße $U'_d = 0$ erfolgt in beiden Fällen die Bestimmung von $\varphi_d$ unabhängig von der Leistung $P_M$ des modulierten Lichts. Ein Nachteil besteht hier jedoch in der Begrenzung des Eindeutigkeitsbereiches auf $180°$.

Fall b): bei $U'_d$ = maximal stellt sich ein Phasenwinkel $\Delta\varphi = 180°$ ein. $\varphi_{tof}$ lässt sich über $\varphi_{tof} = 180° - \varphi_d$ bestimmen, die entsprechenden zur Phasenverzögerung $\varphi_d$ proportionalen Spannungswerte ergeben sich analog zu Fall a). Ein zusätzlicher Vorteil gegenüber Fall a) besteht in der vollständigen Trennung von Fremdlicht und moduliertem Licht. Für $\Delta\varphi = 180°$ wird gemäß Gl. (1.1) bzw. (2.1) der auf dem modulierten Licht beruhende Spannungsanteil in $U_a$ Null, in $U_b$ nach Gleichung (1.2) bzw. (2.2) dagegen maximal. Damit ist der Betrag von $U_d$ in Gl. (3) bzw. (4) nur noch proportional zur Leistung $P_M$ der eingefallenen modulierten Lichtmenge. Zudem wird an dem entsprechenden gegenüberliegenden Gate nur ein der Hintergrundlichtmenge proportionales Spannungssignal erzeugt, somit ist $U_a$ proportional zur Leistung $P_H$ des Hintergrundlichtes. Im Gegensatz zu Fall a) beträgt der Eindeutigkeitsbereich $360°$.

Man erhält bei dieser Anordnung erstmals in einer einzigen Messaufnahme spannungsproportionale Signale zu Phasendifferenz, Leistung des modulierten Lichtes und Leistung des Hintergrundlichtes. Die entsprechenden Messwerte sind direkt analog oder digital weiterverarbeitbar, z.B. für eine geeignete Mittelung.

Fall c): $U'_d$ = Minimal liefert das gleiche Ergebnis wie Fall b), lediglich werden die Ausgangsspannungen $U_a$, $U_b$ und somit das Vorzeichen von $U_d$ getauscht.

Es ist auch eine Einstellung auf andere Zielwerte möglich, z. B. Bereiche maximaler Steigung.

Die Art der Signalvorverarbeitung hängt von der Art der Ausgangssignale des PMD-Elements PMD ab. Bei integrierenden PMD-Elementen PMD nach [Schwarte, Patent DE19704496 A1] schaltet man typischerweise einen Differenzierer TDiff nach, bei ebenfalls möglichen PMD-Elementen PMD ohne integrierenden Ausgang kann oft auf die Signalvorverarbeitung verzichtet werden, dann gilt $U_d = U'_d$.

Die Dimensionierung der Regelstrecke CTR kann z.B. nach [H. Unbehauen, "Regelungstechnik Bd. 1-3", Vieweg Verlag, Wiesbaden] durchgeführt werden.

Zur Realisierung des PMD-Systems wird bevorzugt ein rauscharme und reproduzierbare Laufzeitverzögerungen lieferndes Stellglied zur Phasenverzögerung, hier: ein Phasenschieber PS, verwendet. Alternativ oder zusätzlich kann auch eine Messung der Phase mittels eines genauen Phasenkomparator PCOMP erfolgen. Aufbau und Funktionsprinzip des Phasenkomparators sind z. B. in U. Rhode, "Microwave and Wireless Synthesizers", Kap. 4.4, S. 288 ff, 1997, Wiley Verlag, New York; M. Meade, "Lock-in amplifiers: principles and applications", Kap. 3 S. 31 ff. 1983 IEE Electrical Measurement Series 1 oder Analog Devices, "Data Sheet AD9901", rev. B, beschrieben.

Das PMD-System kann auch mit anderen periodischen Modulationssignalen $U_{mod}$, $\overline{U}_{mod}$, $U_{PMDmod}$, $\overline{U}_{PMDmod}$, $U_{Txmod}$ betrieben werden, z. B. Rechteck- oder Dreiecksignalen.

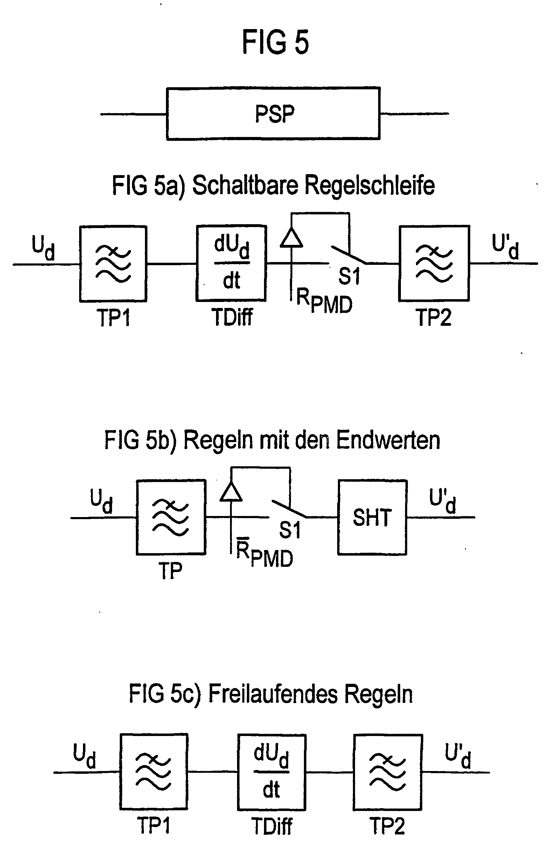

Figur 5 zeigt in den Teilfiguren 5a bis 5c drei Ausführungsformen der Einrichtung zur Signalvorverarbeitung PSP für einen PMD-Baustein PMD mit integrierendem Ausgang. Dabei wird in regelmäßigen Abständen ein Resetsignal R ausgelöst (siehe Fig. 1).

In Figur 5a wird das links einlaufende sägezahnförmige Differenzsignal $U_d$ (siehe Fig. 1) durch einen Tiefpassfilter TP1 tiefpassgefiltert und zusätzlich in einem Differenzierer TDiff zeitlich differenziert. Das Tiefpassfilter TP1 und der Differenzierer TDiff können als ein Baustein oder getrennt ausgeführt sein. Mittels eines durch das Resetsignal R gesteuerten Schalters S1 wird die Regelschleife CTR nur geschlossen, wenn kein Resetsignal R anliegt. Ein anschließender zweiter Tiefpassfilter TP2 dient zur Unterdrückung der Schaltspikes.

Bei diesem Verfahren steht nur die Regelzeit $t_i$ zwischen zwei Resetsignalen R zum Einschwingen des Regelkreises zur Verfügung, während der Resetzeit $t_R$ ist die Messaufnahme unterbrochen. Die Aufnahme des zur Entfernung proportionalen Spannungswertes erfolgt dabei zweckmäßiger Weise im eingeschwungenen Zustand direkt vor dem Öffnen des Schalters S1.

Figur 5b zeigt eine Anordnung, bei welcher der vor dem Auslösen des invertierten Resetsignals $\bar{R}$ erreichte Spitzenwert mittels eines Sample-and-Hold-Tors SHT abgetastet und dieser als Regelgröße $U'_d$ verwendet wird. Dadurch werden die bei der Anordnung in Figur 5a entstehenden Störungen beim Öffnen und Schließen der Regelschleife vermieden, die Lösung ist allerdings relativ langsam. Ein erster Tiefpassfilter TP1 dient hier zur Anpassung der Signalbandbreite an die Schaltgeschwindigkeit des "Sample and Hold"-Tores SHT. S1 kann auch mit dem nicht-invertierten Resetsignal R geschaltet werden.

Figur 5c zeigt eine Anordnung, bei der kein Schalter verwendet wird. Hier wird das Signal $U_d$ mittels des ersten Tiefpassfilters TP1 geglättet, differenziert und mittels des zweiten Tiefpassfilters TP2 gleichgerichtet. Die so erhaltene Regelgröße $U'_d$ wird auf die Regelstrecke CTR gegeben. In diesem Fall wird bevorzugt $U'_d = 0$ gewählt werden. Damit erhält man idealerweise eine konstante Regelgröße $U'_d$, da $U'_d$ während der Resetphase Null ist (siehe Fig. 1), und während der Messphase die Regelgröße $U'_d$ durch den Regelkreis auf Null gehalten wird.

Der Betrieb mit $U'_d$ = maximal ist ebenso möglich, erfordert jedoch auf Grund der Schwankungen von $U'_d$ eine exaktere Auslegung der Tiefpassfilter TP1,TP2. Wie schon in der Anordnung in Figur 5a dient TP1 zur Glättung der Sprünge des Sägezahnsignals. Die Grenzfrequenz des ersten Tiefpassfilters TP1 wird daher analog zu den bei Anordnung in Figur 5a gemachten Überlegungen auf etwa 5,5 $f_{ti}$ ausgelegt.

Der zweite Tiefpassfilter TP2 dient hier zur kompletten Glättung des differenzierten Signals. Bei der Bestimmung der Grenzfrequenz muss dabei zwischen einem möglichst schnellen Einregeln, das eine höhere Grenzfrequenz erfordert, und einer guten Glättung des gleichgerichteten Signals, das eine niedrigere Grenzfrequenz erfordert, gewählt werden. Ein möglicher Kompromiss liegt hier bei einer Grenzfrequenz des zweiten Tiefpassfilters TP2, die etwa $0{,}3 \cdot f_{ti}$ entspricht. Für PMD-Ausgangssignale $U_a, U_b$ mit einer Frequenz von ca. 1 kHz (siehe Fig. 1) ergeben sich dann Grenzfrequenzen von 7,5 kHz für den ersten Tiefpassfilter TP1, und ca. 300 Hz für den zweiten Tiefpassfilter TP2.

Selbstverständlich sind auch andere Methoden zur Signalvorverarbeitung anwendbar.

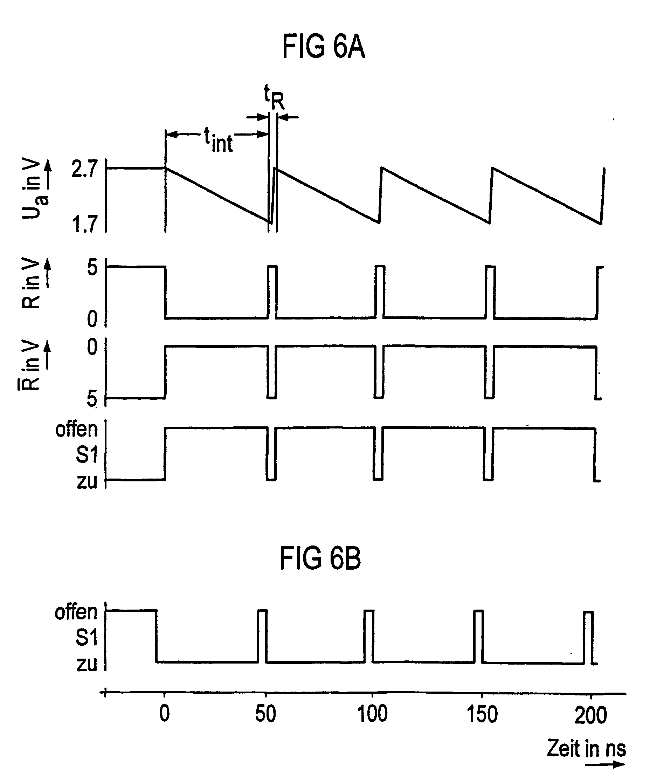

Figur 6 zeigt verschiedene (V,t)-Signalverläufe eines PMD-Systems mit Regelschleife, nämlich von oben nach unten: das Ausgangssignal $U_a$ des PMD-Bausteins PMD, das Resetsignal R, das invertierte Resetsignal $\bar{R}$, einen Schaltverlauf des Schalters S1 aus Figur 5a und einen Schaltverlauf des Schalters S1 aus Figur 5b.

Der mit "a)" markierte Signalverlauf zeigt das entsprechende Timing des Schalters S1 aus Fig. 5a. Die Wahl der Grenzfrequenz der Tiefpässe TP1,TP2 ist bei dieser Anordnung wichtig. Einerseits soll durch den ersten Tiefpassfilter TP1 der sägezahnförmige Verlauf der Differenzspannung $U_d$ soweit geglättet werden, dass die steilen Anstiegsflanken keine zu großen Sprünge des nachgeschalteten Differenzierers TDiff verursachen. Andererseits soll der fallende Teil des Signals möglichst linear und damit als konstanter Wert nach dem Differenzieren als Regelgröße $U'_d$ zur Verfügung stehen. Es wird bevorzugt, die Grundwelle und die ersten beiden Oberwellen des Signals zu verwenden, also für den ersten Tiefpassfilter TP1 eine Grenzfrequenz von etwa $5{,}5 \cdot f_{ti}$ zu wählen. Der zweite Tiefpassfilter TP2 dient dann lediglich zum Herausfiltern zusätzlicher, durch den Differenzierer verursachter Störungen. Seine Grenzfrequenz wird daher identisch mit der des ersten Tiefpassfilters gewählt. Für Ausgangssignale mit einer Frequenz von etwa 1 kHz (siehe Fig. 1) ergibt sich damit sowohl für den ersten Tiefpassfilter TP1 als auch für den zweiten Tiefpassfilter TP2 eine Grenzfrequenz von ca. 7,5 kHz.

Der mit "b)" markierte Signalverlauf zeigt das entsprechende Timing für den Schalter S1 in Fig. 5b. Die Wahl der Grenzfrequenz des Tiefpassfilters TP ergibt sich hier direkt aus der Abtastzeit des Abtasttores, bevorzugt des Sample-and-Hold-Tores SHT. Gemäß Nyquistkriterium (Abtasttheorem) muss die Frequenz des abgetasteten Signals auf die Hälfte der Samplingfrequenz begrenzt werden [J. Proakis, D. Manolakis, "Digital Signal Processing", Kap. 6, S. 395 ff., Second Edition, MacMillan Publishing]. Somit ergibt sich für ein Abtasttor, z.B. mit einer Samplingzeit $t_s$ von 10 µs, eine Grenzfrequenz des Tiefpassfilters von $f_g = 1/(2 \cdot t_s) = 50$ kHz.

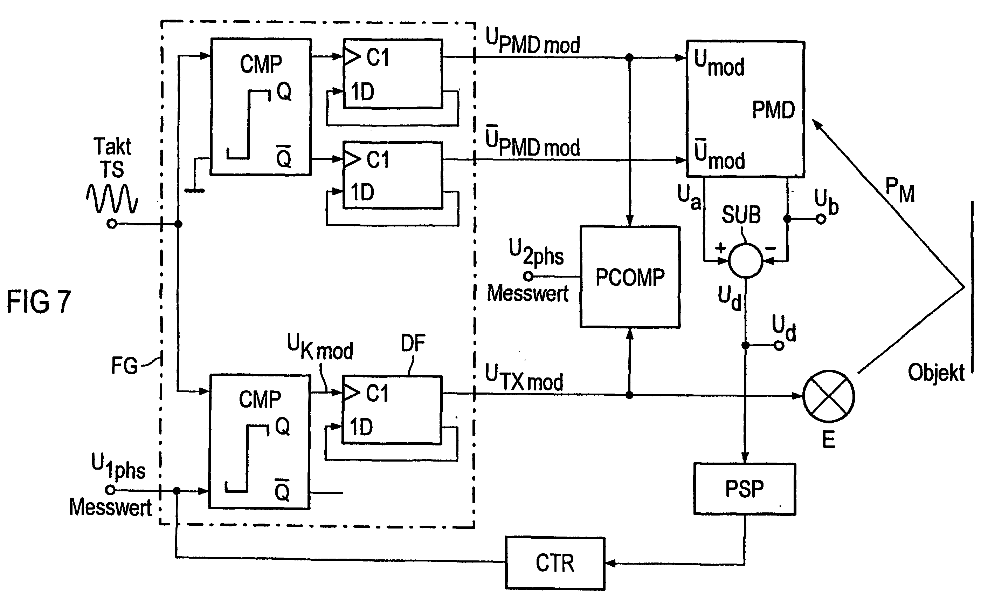

Figur 7 zeigt als Schaltskizze ein PMD-System, bei dem der Phasenschieber PS als Komparator CMP mit einem D-Flipflop DF als Takthalbierer aufgebaut ist.

Hierbei wird der Komparator CMF mit einem monotonen, kontinuierlich zwischen Minimal- und Maximalwert alternierenden Taktsignal TS, z. B. sinus- oder dreieckförmig, angesteuert. Durch eine Schwellspannung $U_s$ wird der Ein- und Ausschaltzeitpunkt festgelegt. Bei Erreichen der Schwellspannung $U_s$ schaltet der Komparatorausgang seine Ausgangsspannung $U_{Kmod}$ auf "logisch eins", bei Unterschreiten der Schwellspannung $U_s$ schaltet der Ausgang auf "logisch Null" zurück. Dies führt neben der Variation des Schaltzeitpunktes zur Variation der entsprechenden Pulsbreiten, weswegen ein Takthalbierer gemäß [U. Tietze, T. Schenk, "Halbleiter-Schaltungstechnik", Kapitel 10, S- 232 ff, zehnte Auflage, Springer Verlag Berlin] nachgeschaltet ist, der das Taktverhältnis 1:1 wieder herstellt.

Der Vorteil dieser Realisierung des Phasenschiebers PS besteht in der einfachen Realisierbarkeit mittels Standardbauteilen (z.B. CMOS-Logik), und in der einfachen Integrierbarkeit in zukünftige PMD-CMOS-Chips. Der Nachteil besteht in dem auf 90° beschränkten Einstellbereich für die Phasenverzögerung $\varphi_d$.

Zur Umgehung dieser Einschränkung wie auch zur Vermeidung von auftretenden Nichtlinearitäten am Rande des Regelbereichs kann die Anordnung durch zusätzliche, zuschaltbare Phasenschieber PS definierter Verzögerung erweitert werden. Eine weitere Realisierungsmöglichkeit ist der Einsatz von Filtern mit entsprechenden Gruppenlaufzeiten als schaltbare Verzögerer.

An Stelle des Regelkreises zur Einstellung der Phasenverzögerung $\varphi_d$ kann auch ein Regelkreis zur Einstellung der Modulationsfrequenz $f_{mod}$ verwendet werden.

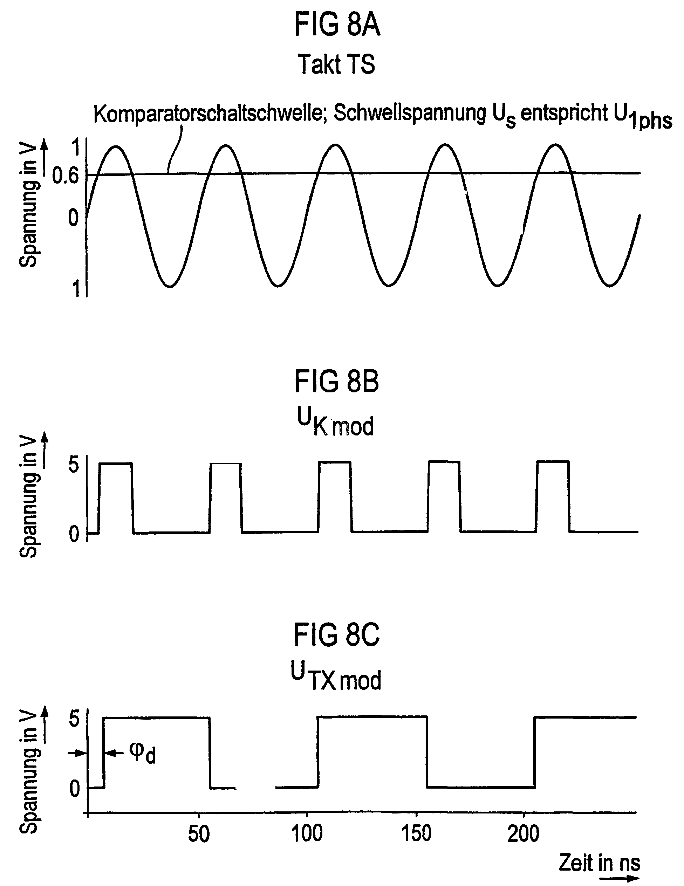

Figur 8 zeigt als (V,t)-Auftragung die Schaltverläufe des PMD-Systems in Figur 7 für ein sinusförmiges mittelwertfreies Taktsignal TS, die Ausgangsspannung $U_{Kmod}$ des D-Flipflops DF und die Modulationsspannung $U_{Txmod}$, mittels der die Amplitude des Senders E gesteuert wird.

Insbesondere ist eine Anordnung vorteilhaft, bei der eine Matrix aus einzelnen PMD-Elementen PMD verwendet wird, und in jedem der PMD-Elemente PMD ein Phasenschieber PS nach diesem Ausführungsbeispiel mit entsprechender Regelstrecke integriert ist. Dadurch steht in jedem PMD-Baustein PMD ein direkt von der Laufzeit $\tau_{tof}$ bzw. der Entfernung vom Objekt abhängiges Signal, typischerweise ein Spannungswert, zur Verfügung.

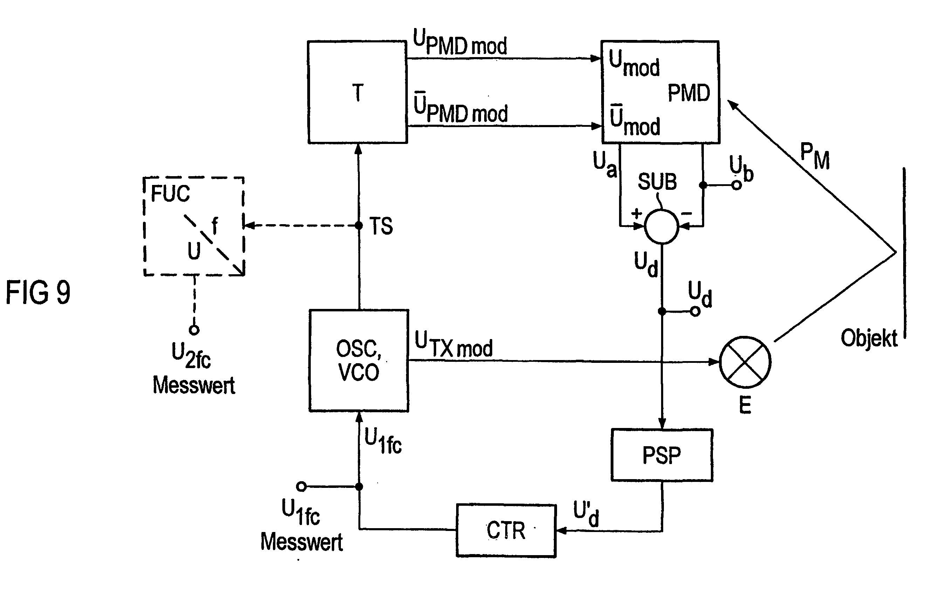

Figur 9 zeigt als Schaltskizze ein PMD-System mit veränderbarer Modulationsfrequenz $f_{mod}$ und Regelstrecke CTR.

Wie bereits zuvor beim Phasenregelkreis ist auch hier beim Spannungsregelkreis das direkte Erzeugen einer entfernungsproportionalen Spannung möglich. Die Anordnung besteht aus einem VCO-Regler VCO als verstimmbaren Oszillator OSC, auf den als Stellsignal die Ausgangsspannung $U_{1fc}$ der Regelstrecke CTR wirkt. Das Ausgangssignal des VCO-Reglers VCO wird wie zuvor im PMD-Treiber T in die notwendigen Modulationssignale $U_{mod}, \overline{U}_{mod}$ für das PMD-Element PMD umgewandelt und gelangt von dort auf das PMD-Element PMD. Der Sender E wird wiederum vom Ausgangssignal des VCO-Reglers VCO in der Intensität moduliert. Die modulierte Welle gelangt entweder direkt oder reflektiert auf das PMD-Element PMD und erzeugt dort, wie zuvor beschrieben, ein Differenzsignal $U_d$ proportional zur Phasenverschiebung $\Delta\varphi$. Idealerweise treten keine zusätzlichen Verzögerungen durch Laufzeiten oder Modulationen auf, und es gilt dann: $\Delta\varphi = \varphi_{tof}$. Das Differenzsignal wird wiederum, ggf. vorverarbeitet als Regelgröße $U'_d$, auf die Regelstrecke CTR gegeben.

Die Regelstrecke CTR stellt dann diejenige Modulationsfrequenz $f_{mod}$ ein, für die die Regelgröße

    a) $U'_d$ = Null,
    b) $U'_d$ = maximal, oder
    c) $U'_d$ = minimal

ist.

Im Fall a) stellt sich dann diejenige Modulationsfrequenz $f_{mod}$ ein, deren halbe Periode T/2 ein ganzzahliger Teiler der Laufzeitdifferenz $\tau_{tof}$ ist.

Im Fall b) stellt sich dagegen diejenige Modulationsfrequenz $f_{mod}$ ein, deren Viertelperiode oder deren Viertelperiode plus einem ganzzahligen Vielfachen der Grundperiode ein Teiler der Laufzeitdifferenz ist: $\tau_{tof}$ = n·T+T/4.

Im Fall c) stellt sich analog eine Laufzeitdifferenz $\tau_{tof}$ = n·T+3·T/4 ein. Zur Vermeidung von Mehrdeutigkeiten wird bevorzugt zu Beginn der Regelung die niedrigste mögliche Frequenz als Startpunkt gewählt. Ausgehend von dieser wird dann in Richtung der ersten nächst größeren Frequenz geregelt, die den gewünschten Wert von $U'_d$ einstellt. Somit gilt dann für die Laufzeitdifferenz $\tau_{tof}$

    a) $\tau_{tof}$ = T/2,
    b) $\tau_{tof}$ = T/4,
    c) $\tau_{tof}$ = 3T/4.

Die Frequenz lässt sich über die Messung der am VCO-Regler VCO eingestellten Spannung $U_{1fc}$ bestimmen, oder bevorzugt über einen zusätzlichen f-zu-U-Konverter (FUC). Die Wahl der Zielgrößen nach b) oder c) bietet analog zu den entsprechenden Verfahren bei Phasenregelung die direkte Trennung zwischen Hintergrundlicht und moduliertem Licht.

Die einstellbare minimale und maximale Frequenz $f_{min}$ und $f_{max}$ legen den eindeutigen Messbereich fest. Dabei gilt für den Mindestabstand $d_{min}$ zum Sensor und die maximale Entfernung $d_{max}$:

    a) $d_{min} = \frac{c}{4 \cdot f_{max}}$, $d_{max} = \frac{c}{4 \cdot f_{min}}$
    b) $d_{min} = \frac{c}{8 \cdot f_{max}}$, $d_{max} = \frac{c}{8 \cdot f_{min}}$
    c) $d_{min} = \frac{3c}{8 \cdot f_{max}}$, $d_{max} = \frac{3c}{8 \cdot f_{min}}$

Für PMD-Elemente PMD mit $f_{min}$ = 10 MHz und $f_{max}$ = 160 MHz ergeben sich dann Messbereiche von:

    a) 0,5 m - 7,5 m,
    b) 0,25 m - 3,75 m,
    c) 0,75 m - 11,25 m.

Die Aufnahme der Regelgröße $U'_d$ kann analog zu den für die Phasenregelschleife vorgeschlagenen Methoden erfolgen, da die Integrationszeit typischer Ausgangssignale (siehe Fig. 1) innerhalb der vorgeschlagenen Bandbreite idealerweise unabhängig vom verwendeten Modulationsverfahren sind.

Für eine f-zu-U-Wandlung können f/U-Wandler mit analoger Ausgangsspannung verwendet werden. f/U-Wandler sind z. B. in [E. Schrüfer, "Elektrische Messtechnik", Kapitel 6.4.2, S. 385 ff, 4. Auflage, Carl Hanser Verlag München oder D. Nührmann, "Praxis der Messtechnik", Kapitel 8, Franzis Verlag) beschrieben. Bevorzugt erfolgt die Frequenzbestimmung mittels eines Zählers, z.B. nach [D. Nührmann, "Praxis der Messtechnik", Kapitel 8.2, Franzis Verlag], der bei jedem Impuls um eins inkrementiert wird. Durch Auslesen des Zählerstandes in festen Zeitintervallen liegt dann direkt ein digitales Wort für die Modulationsfrequenz $f_{mod}$ und somit die Laufzeitdifferenz $\tau_{tof}$ vor, eine anschließende A/D-Wandlung ist zur Weiterverarbeitung im Mikroprozessor MP dann nicht mehr notwendig.

Die Frequenzerzeugung erfolgt in dieser Figur bevorzugt mittels des VCO-Reglers VCO. Andere verstimmbare Frequenzquellen wie z. B. digitale Frequenzsynthesizer, beispielsweise PLL-Synthesizer oder Direct Digital Synthesizer (DDS), können aber an Stelle eines VCO-Reglers VCO ebenfalls eingesetzt werden. Bei den hier gezeigten Ausführungsbeispielen von PMD-Systemen mit Regelschleife ist der Phasenschieber PS in der Regel vor den Sender E geschaltet. Der Phasenschieber PS, und allgemein ein Phasenverzögerer, kann aber ebenso vor das PMD-Element PMD geschaltet werden. Lediglich die Phasenbeziehungen müssen dann für eine negative Verzögerung umgestellt werden.

Die PMD-Systeme mit Regelschleife sind nicht auf Lichtwellen beschränkt. Vielmehr kann die Methode allgemein für Elemente mit PMD-typischer Anordnung zum Empfang elektromagnetische Wellen, z. B. Mikrowellen, verwendet werden. Entsprechend können z. B. Sender E in Form von Lasern, Dioden und Dioden-Arrays, Leuchtstofflampen, aber auch Mikrowellensendern und Radarsendern vorliegen.

**Patentansprüche**

1. Photoelectronic Mixing Device oder PMD-System, aufweisend

   - mindestens ein PMD-Element (PMD),
   - mindestens einen intensitätsmodulierbaren Sender (E),
   - mindestens eine Ansteuerelektronik (FG), mittels der das PMD-Element (PMD) und der Sender (E) mit jeweils mindestens einer Modulationsspannung ($U_{mod}$, $\bar{U}_{mod}$, $U_{Txmod}$) gleicher Modulationsfrequenz ($f_{mod}$) ansteuerbar sind, und
   mittels der die zwei Modulationsspannungen gegeneinander mit einer veränderbaren Phasenverschiebung versehbar sind, und
   mittels der über ein Stellsignal die Phasenverschiebung ($\Delta\varphi$) veränderbar ist,

   **dadurch gekennzeichnet, dass**
   eine Regelstrecke (CTR) vorhanden ist, in die als eine Regelgröße ($U'_d$) mindestens ein Ausgangssignal ($U_a, U_b, U_d$) des PMD-Elements (PMD) einspeisbar ist, und deren Ausgangssignal ($U_{1phs}$, $U_{1fc}$) als Stellsignal in einen Phasenverschieber (PS) der Ansteuerelektronik (FG) einspeisbar ist, wobei
   durch die Regelstrecke (CTR) die Regelgröße ($U'_d$) auf den Wert einer vorgegebenen Zielgröße einstellbar ist.

2. PMD-System nach Anspruch 1, bei dem der Regelstrecke (CTR) eine Einrichtung zur Signalvorverarbeitung (PSP) vorgeschaltet ist.

3. PMD-System nach Anspruch 2, bei dem die Einrichtung zur Signalvorverarbeitung (PSP) einen ersten Tiefpassfilter (TP1), dahinter eine Vorrichtung zur zeitlichen Differenzierung (TDiff), dahinter einen durch ein Resetsignal ($R,\bar{R}$) steuerbaren Schalter (S1) und dahinter einen zweiten Tiefpassfilter (TP2) aufweist.

4. PMD-System nach Anspruch 2, bei dem die Einrichtung zur Signalvorverarbeitung (PSP) einen ersten Tiefpassfilter (TP1), dahinter einen durch ein Resetsignal (R) steuerbaren Schalter (S1) und dahinter ein Sample-and-Hold-Tor (SHT) aufweist.

5. PMD-System nach Anspruch 2, bei dem die Einrichtung zur Signalvorverarbeitung (PSP) einen ersten Tiefpassfilter (TP1), dahinter eine Vorrichtung zur zeitlichen Differenzierung und dahinter einen zweiten Tiefpassfilter (TP2) aufweist.

6. PMD-System nach einem der Ansprüche 3 oder 5, bei dem eine Grenzfrequenz des ersten Tiefpassfilters (TP1) im Bereich des 5,5-fachen der Integrationszeit ($f_{ti}$) liegt.

7. PMD-System nach Anspruche 6, bei dem eine Grenzfrequenz des zweiten Tiefpassfilters (TP2) im Bereich des dreifachen der Integrationszeit ($f_{ti}$) liegt.

8. PMD-System nach einem der Ansprüche 1 bis 7, bei dem mittels der Ansteuerelektronik (FG) die das PMD-Element (PMD) ansteuernde mindestens eine Modulationsspannung ($U_{mod}$, $\bar{U}_{mod}$) und die den Sender (E) ansteuernde mindestens eine Modulationsspannung ($U_{Txmod}$) gegeneinander mit einer Phasenverzögerung ($\varphi_d$) versehbar sind.

9. PMD-System nach Anspruch 8, bei dem ein Phasenkomparator (PCOMP) vorhanden ist, an dessen einem Eingang eine das PMD-Element (PMD) ansteuernde Modulationsspannung ($U_{mod}$, $\bar{U}_{mod}$) anlegbar ist und an dessen weiterem Eingang eine den Sender (E) ansteuernde Modulationsspannung ($U_{TXmod}$) anlegbar ist, woraus eine Phasendifferenz der eingehenden Modulationsspannungen ($U_{mod}$,$\bar{U}_{mod}$,$U_{TXmod}$) bestimmbar ist.

10. PMD-System nach einem der Ansprüche 8 oder 9, bei dem
die Ansteuerelektronik (FG) mindestens beinhaltet

- einen steuerbaren Treiber (T), der das PMD-Element (PMD) mit der mindestens einen aus einem Taktsignal (TS) erzeugten Modulationsspannung ($U_{mod}$,$\bar{U}_{mod}$) versorgt,
- einen durch die Regelstrecke (CTR) steuerbaren Phasenverzögerer (PS), mittels dessen das Taktsignal (TS) als Modulationsspannung ($U_{Txmod}$) an den Sender (E) mit einer Phasenverzögerung ($\varphi_d$) weiterleitbar ist.

11. PMD-System nach Anspruch 10, bei dem
der Phasenverzögerer in Form eines Phasenschiebers (PS) vorliegt, welcher einen Komparator (CMP) mit einem nachgeschalteten D-Flipflop (DF) als Takthalbierer enthält.

12. PMD-System nach Anspruch 11, bei dem
mindestens ein Phasenschieber (PS) zusammen mit je mindestens einer Regelstrecke (CTR) in das PMD-Element (PMD) integriert ist.

13. PMD-System nach Anspruch 12, welches
mehrere PMD-Elemente (PMD) umfasst.

14. PMD-System nach einem der Ansprüche 1 bis 7, bei dem mittels der Ansteuerelektronik (FG) die Modulationsfrequenz ($f_{mod}$) einstellbar ist.

15. PMD-System nach Anspruch 14, bei dem
die Ansteuerelektronik (FG) mindestens beinhaltet

- einen steuerbaren Treiber (T), der das PMD-Element (PMD) mit der mindestens einen aus einem Taktsignal (TS) erzeugten Modulationsspannung ($U_{mod}$, $\bar{U}_{mod}$) versorgt,
- einen verstimmbare Frequenzquelle (OSC), mittels dessen das Taktsignal (TS) für den Treiber (T) und die Modulationsspannung ($U_{Txmod}$) für den Sender (E) erzeugbar ist.

16. PMD-System nach Anspruch 15, bei dem
das Taktsignal (TS) der verstimmbaren Frequenzquelle (OSC) in einen f-zu-U-Konverter (FUC), insbesondere einen inkrementell zählenden einen f-zu-U-Konverter (FUC), einspeisbar ist.

17. PMD-System nach einem der Ansprüche 1 bis 16, bei dem
als Regelgröße ($U'_d$) die Werte Null, minimal oder maximal einstellbar sind.

18. Verfahren zur Regelung eines PMD-Systems nach einem der Ansprüche 14 bis 16, bei dem zu Beginn einer Regelung die niedrigste Frequenz als Startpunkt gewählt wird, und dann in Richtung der nächsthöheren Frequenz geregelt wird, welche den gewünschten Wert der Regelgröße ($U'_d$) einstellt.

19. Verfahren zur Regelung eines PMD-Systems, das mindestens aufweist:

- ein PMD-Element (PMD),
- einen Sender (E) zur intensitätsmodulierten Aussendung elektromagnetischer Wellen,
- mindestens eine Ansteuerelektronik (FG), mittels der das PMD-Element (PMD) und der Sender (E) mit jeweils mindestens einer Modulationsspannung ($U_{mod}$,$\bar{U}_{mod}$,$U_{Txmod}$) gleicher Modulationsfrequenz ($f_{mod}$) ansteuerbar sind, mittels der die zwei Modulationsspannungen gegeneinander mit einer Phaserverschiebung versehbar sind, und mittels der über ein Stellsignal die Phasenverschiebung ($\Delta\varphi$) veränderbar ist,

**dadurch gekennzeichnet, dass**
mittels einer Regelstrecke (CTR) das Stellsignal so auf die Ansteuerelektronik (FG) gegeben wird, dass eine das PMD-System charakterisierende Regelgröße ($U'_d$) selbstständig auf einen Wert einer vorgegebenen Zielgröße eingestellt wird, wobei mindestens ein Ausgangssignal ($U_a$,$U_b$,$U_d$) des PMD-Elements (PMD) zu einer Bestimmung der Regelgröße ($U'_d$) herangezogen wird.

20. Verfahren nach Anspruch 19, bei dem
die Phasenverschiebung ($\Delta\varphi$) durch eine Verstimmung der Phasenverzögerung ($\varphi_d$) und/oder der Modulationsfrequenz ($f_{mod}$) verändert wird.

**Claims**

1. Photoelectronic Mixing Device, or PMD system, comprising

- at least one PMD element (PMD),
- at least one intensity-modulatable transmitter (E),
- at least one controlling electronics device (FG) by means of which the PMD element (PMD) and the transmitter (E) can each be controlled using at least one modulation voltage ($U_{mod}$, $\bar{U}_{mod}$, $U_{TXmod}$) of the same modulation frequency ($f_{mod}$)

and

by means of which the phase shift ($\Delta\varphi$) can be modified via an actuating signal,

**characterized in that**
a controlled system (CTR) is provided into which at least one output signal ($U_a$, $U_b$, $U_d$) of the PMD element (PMD) can be fed as a control variable ($U'_d$), and whose output signal ($U_{1phs}$, $U_{1fc}$) can be fed as an actuating signal into the controlling electronics device (FG),
where
the control variable ($U'_d$) can be set to the value of a predefined target variable by the controlled system (CTR).

2. PMD system according to Claim 1, wherein
a signal pre-processing device (PSP) is inserted in the circuit ahead of the controlled system (CTR).

3. PMD system according to Claim 2, wherein
the signal preprocessing device (PSP) comprises a first low-pass filter (TP1), followed by a device for time differentiation (TDiff), followed by a switch (S1) that is controllable by means of a reset signal (R, $\bar{R}$), and followed by a second low-pass filter (TP2).

4. PMD system according to Claim 2, wherein
the signal preprocessing device (PSP) comprises a first low-pass filter (TP1), followed by a switch (S1) that is controllable by means of a reset signal (R), and followed by a sample-and-hold gate (SHG).

5. PMD system according to Claim 2, wherein
the signal preprocessing device (PSP) comprises a first low-pass filter (TP1), followed by a device for time differentiation (TDiff), and followed by a second low-pass filter (TP2).

6. PMD system according to one of the claims 3 or 5, wherein
a limit frequency of the first low-pass filter (TP1) lies in the range of 5.5 times the integration time ($f_{ti}$).

7. PMD system according to Claim 6, wherein
a limit frequency of the second low-pass filter (TP2) lies in the range of three times the integration time ($f_{ti}$).

8. PMD system according to one of the Claims 1 to 7, wherein
the at least one modulation voltage ($U_{mod}$, $\bar{U}_{mod}$) controlling the PMD element (PMD) and the at least one modulation voltage ($U_{TXmod}$) controlling the transmitter (E) are provided with a phase delay ($\varphi d$) with respect to each other by means of the controlling electronics device (FG).

9. PMD system according to Claim 8, wherein
a phase comparator (PCOMP) is provided, at whose one input a modulation voltage ($U_{mod}$, $\bar{U}_{mod}$) controlling the PMD element (PMD) can be applied and at whose further input a modulation voltage ($U_{TXmod}$) controlling the transmitter (E) can be applied, from which a phase difference of the incoming modulation voltages ($U_{mod}$, $\bar{U}_{mod}$, $U_{TXmod}$) can be determined.

10. PMD system according to one of the claims 8 or 9, wherein
the controlling electronics device (FG) at least includes

- a controllable driver (T) which supplies the PMD element (PMD) with the at least one modulation voltage ($U_{mod}$, $\bar{U}_{mod}$) generated from a clock signal (TS),
- a phase delay element (PS) controllable by the controlled system (CTR), by means of which the clock signal (TS) can be forwarded as a modulation voltage ($U_{TXmod}$) to the transmitter (E) with a phase delay ($\varphi d$).

11. PMD system according to Claim 10, wherein
the phase delay element is provided in the form of a phase shifter (PS) which contains a comparator (CMP) with a D flip-flop (DF) connected in series at its output as a clock splitter.

12. PMD system according to Claim 11, wherein
at least one phase shifter (PS) together with in each case at least one controlled system (CTR) is integrated into the PMD element (PMD).

13. PMD system according to Claim 12, which
comprises multiple PMD elements (PMD).

14. PMD system according to one of the claims 1 to 7, wherein the modulation frequency ($f_{mod}$) can be set by means of the controlling electronic device (FG).

15. PMD system according to Claim 14, wherein
the controlling electronics device (FG) at least includes

- a controllable driver (T) which supplies the PMD element (PMD) with the at least one modulation voltage ($U_{mod}$, $\bar{U}_{mod}$) generated from a clock signal (TS),
- a detunable frequency source (OSC), by means of which the clock signal (TS) can be generated for the driver (T) and the modulation voltage ($U_{TXmod}$) can be generated for the transmitter (E).

16. PMD system according to Claim 15, wherein

the clock signal (TS) of the detunable frequency source (OSC) can be fed into an f-to-U converter (FUC), particularly an incrementally counting f-to-U converter (FUC).

17. PMD system according to one of the claims 1 to 16, wherein
the values zero, minimum or maximum can be set as control variable (U'$_d$).

18. Method for controlling a PMD system according to one of the claims 14 to 16, wherein the lowest frequency is selected as the starting point at the beginning of a control operation and is then adjusted in the direction of the next-higher frequency, which sets the desired value of the control variable (U'$_d$).

19. Method for controlling a PMD system which comprises at least:

   - one PMD element (PMD),
   - one transmitter (E) for intensity-modulated transmission of electromagnetic waves,
   - at least one controlling electronics device (FG), by means of which the PMD element (PMD) and the transmitter (E) can in each case be controlled using at least one modulation voltage (U$_{mod}$, $\bar{U}_{mod}$, U$_{TXmod}$) of the same modulation frequency (f$_{mod}$),
   by means of which the two modulation voltages are provided with a phase shift with respect to each other
   and
   by means of which the phase shift ($\Delta\varphi$) can be modified via an actuating signal,

   **characterized in that**
   the actuating signal is applied to the controlling electronics device (FG) by means of a controlled system (CTR) such that a control variable (U'$_d$) characterizing the PMD system is set automatically to a value of a predefined target variable, with at least one output signal (U$_a$, U$_b$, U$_d$) of the PMD element (PMD) being used to determine the control variable (U'$_d$).

20. Method according to Claim 19, wherein
the phase shift ($\Delta\varphi$) is modified by a detuning of the phase delay ($\varphi$d) and/or the modulation frequency (f$_{mod}$).

## Revendications

1. Système Photoelectronic Mixing Device ou PMD, présentant :

   - au moins un élément de PMD (PMD)

   - au moins un émetteur (E) modulable en intensité,
   - au moins une électronique de commande (FG), au moyen de laquelle l'élément de PMD (PMD) et l'émetteur (E) peuvent être commandés avec respectivement au moins une tension de modulation (U$_{mod}$, $\bar{U}_{mod}$, U$_{Txmod}$) de fréquence de modulation (f$_{mod}$) identique, et au moyen de laquelle les deux tensions de modulation peuvent être pourvues l'une par rapport à l'autre d'un déphasage variable, et au moyen de laquelle le déphasage ($\Delta\varphi$) peut être varié au moyen d'un signal de commande,

   **caractérisé en ce qu'**il y a un système réglé (CTR) dans lequel au moins un signal de sortie (U$_a$, U$_b$, U$_d$) de l'élément de PMD (PMD) peut être injecté comme une grandeur réglée (U'$_d$), et dont le signal de sortie (U$_{1phs}$, U$_{1fc}$) peut être injecté comme signal de commande dans un déphaseur (PS) de l'électronique de commande (FG), la grandeur réglée (U'$_d$) est ajustable par le système réglé (CTR) à la valeur d'une grandeur cible prédéfinie.

2. Système de PMD selon la revendication 1, sur lequel un appareil pour le traitement préalable du signal (PSP) est monté en amont du système réglé (CTR).

3. Système de PMD selon la revendication 2, sur lequel un appareil pour le traitement préalable du signal (PSP) présente un premier filtre passe-bas (TP1), après un dispositif pour la différenciation dans le temps (TDiff), après un interrupteur (S1) contrôlable par un signal de réinitialisation (R, $\bar{R}$) et après un second filtre passe-bas (TP2).

4. Système de PMD selon la revendication 2, sur lequel l'appareil pour le traitement préalable du signal (PSP) présente un premier filtre passe-bas (TP1), après un interrupteur (S1) contrôlable par un signal de réinitialisation (R) et après une porte de Sample-and-Hold (SHT).

5. Système de PMD selon la revendication 2, sur lequel l'appareil pour le traitement préalable du signal (PSP) présente un premier filtre passe-bas (TP1), après un dispositif pour la différenciation dans le temps et après un second filtre passe-bas (TP2).

6. Système de PMD selon l'une quelconque des revendications 3 ou 5, sur lequel une fréquence limite du premier filtre passe-bas (TP1) se situe dans la plage égale à 5,5 fois le temps d'intégration (f$_{ti}$).

7. Système de PMD selon la revendication 6, sur lequel une fréquence limite du second filtre passe-bas (TP2) se situe dans la zone du triple du temps

d'intégration ($f_{ti}$).

**8.** Système de PMD selon l'une quelconque des revendications 1 à 7, sur lequel au moyen de l'électronique de commande (FG), la au moins une tension de modulation ($U_{mod}$, $\overline{U}_{mod}$) commandant l'élément de PMD (PMD) et la au moins une tension de modulation ($U_{Txmod}$) commandant l'émetteur (E) peuvent être pourvues d'un retard de phase ($\varphi_d$) l'une par rapport à l'autre.

**9.** Système de PMD selon la revendication 8, sur lequel un comparateur de phases (PCOMP) est présent, sur une entrée duquel une tension de modulation ($U_{mod}$, $\overline{U}_{mod}$) commandant l'élément de PMD (PMD) peut être appliquée et sur l'autre entrée duquel une tension de modulation ($U_{Txmod}$) commandant l'émetteur (E) peut être appliquée, de sorte qu'on peut déterminer une différence de phase des tensions de modulation ($U_{mod}$, $\overline{U}_{mod}$, $U_{Txmod}$) entrant.

**10.** Système de PMD selon l'une quelconque des revendications 8 ou 9, sur lequel l'électronique de commande (FG) comprend au moins

- un driver (T) contrôlable, qui alimente l'élément de PMD (PMD) avec la au moins une tension de modulation ($U_{mod}$, $\overline{U}_{mod}$) générée à partir d'un signal de rythme (TS),
- un retardateur de phase (PS) pouvant être commandé par le système réglé (CTR), au moyen duquel le signal de rythme (TS) peut être transmis en tant que tension de modulation ($U_{Txmod}$) à l'émetteur (E) avec un retard de phase ($\varphi_d$).

**11.** Système de PMD selon la revendication 10, sur lequel le retardateur de phase est présent sous la forme d'un déphaseur (PS), qui contient un comparateur (CMP) avec un flip-flop D (DF) placé en aval en tant que diviseur de rythme.

**12.** Système de PMD selon la revendication 11, sur lequel au moins un déphaseur (PS) est intégré conjointement avec au moins un système réglé (CTR) dans l'élément de PMD (PMD).

**13.** Système de PMD selon la revendication 12, qui comprend plusieurs éléments de PMD (PMD).

**14.** Système de PMD selon l'une quelconque des revendications 1 à 7, sur lequel la fréquence de modulation ($f_{mod}$) est ajustable au moyen de l'électronique de commande (FG).

**15.** Système de PMD selon la revendication 14, sur lequel l'électronique de commande (FG) contient au moins

- un driver (T) contrôlable, qui alimente l'élément de PMD (PMD) avec la au moins une tension de modulation ($U_{mod}$, $\overline{U}_{mod}$) générée à partir d'un signal de rythme (TS),
- une source de fréquence (OSC) désaccordable, au moyen de laquelle le signal de rythme (TS) et la tension de modulation ($U_{Txmod}$) peuvent être générés respectivement pour le driver (T) et pour l'émetteur (E).

**16.** Système de PMD selon la revendication 15, sur lequel le signal de rythme (TS) de la source de fréquence (OSC) désaccordable peut être injecté dans un convertisseur f en U (FUC), en particulier un convertisseur f en U (FUC) à comptage incrémentiel.

**17.** Système de PMD selon l'une quelconque des revendications 1 à 16, sur lequel les valeurs zéro, minimum ou maximum sont ajustables en tant que grandeur réglée ($U'_d$).

**18.** Procédé pour le réglage d'un système de PMD selon l'une quelconque des revendications 14 à 16, sur lequel la fréquence la plus basse est choisie comme point de départ au début d'un réglage et ensuite est réglée en direction de la fréquence immédiatement supérieure qui règle la valeur souhaitée de la grandeur réglée ($U'_d$).

**19.** Procédé pour le réglage d'un système de PMD qui présente au moins :

- un élément de PMD (PMD),
- un émetteur (E) pour l'émission modulée en intensité d'ondes électromagnétiques,
- au moins une électronique de commande (FG) au moyen de laquelle l'élément de PMD (PMD) et l'émetteur (E) peuvent être commandés avec respectivement au moins une tension de modulation ($U_{mod}$, $\overline{U}_{mod}$, $U_{Txmod}$) de même fréquence de modulation ($f_{mod}$), au moyen de laquelle les deux tensions de modulation peuvent être pourvues l'une par rapport à l'autre d'un déphasage et au moyen de laquelle le déphasage ($\Delta\varphi$) peut être modifié au moyen d'un signal de commande,

**caractérisé en ce que** le signal de commande est amené à l'électronique de commande (FG) au moyen d'un système réglé (CTR) de telle sorte qu'une grandeur réglée ($U'_d$) caractérisant le système de PMD est réglée de façon autonome sur une valeur d'une grandeur cible prédéfinie, au moins un signal de sortie ($U_a$, $U_b$, $U_d$) de l'élément de PMD (PMD) étant utilisé pour une détermination de la grandeur réglée (U'$_d$).

20. Procédé selon la revendication 19, avec lequel le déphasage ($\Delta\varphi$) est modifié par un désaccord du retard de phase ($\varphi_d$) et/ou de la fréquence de modulation (f$_{mod}$).

**FIG 1**
(Stand der Technik)

$t_R$

$t_{int}$

$U_a$

$U_b$

R

$U_d$

Ch1 500mV    Ch2    500mV         M  500µs   Ch4 ⌠    2.72 V
Ch3 1.00 V

EP 1 332 549 B1

FIG 2
(Stand der Technik)

FIG 3
(Stand der Technik)

FIG 4

# FIG 5

PSP

## FIG 5a) Schaltbare Regelschleife

$U_d$ — TP1 [$\approx$] — TDiff [$\dfrac{dU_d}{dt}$] — $\triangle$ $R_{PMD}$ — S1 — TP2 [$\approx$] — $U'_d$

## FIG 5b) Regeln mit den Endwerten

$U_d$ — TP [$\approx$] — $\triangle$ $\bar{R}_{PMD}$ — S1 — SHT — $U'_d$

## FIG 5c) Freilaufendes Regeln

$U_d$ — TP1 [$\approx$] — TDiff [$\dfrac{dU_d}{dt}$] — TP2 [$\approx$] — $U'_d$

## FIG 6A

## FIG 6B

Zeit in ns

FIG 7

# FIG 8A
## Takt TS

Komparatorschaltschwelle; Schwellspannung $U_S$ entspricht $U_{1phs}$

# FIG 8B
## $U_{K\,mod}$

# FIG 8C
## $U_{TX\,mod}$

$\varphi_d$

Zeit in ns

FIG 9